# EUROPEAN PATENT APPLICATION

(11) **EP 0 716 440 A1**
(43) Date of publication of application: **12.06.1996**
(21) Application number: 95118819.2
(22) Date of filing: 30.11.1995
(51) Int. Cl.: H01J 37/32

(54) **Cooled gas distribution system for a plasma reactor**

(30) Priority: 05.12.1994 US 349294
(71) Applicant: Hughes Aircraft Company, Los Angeles, California 90045-0066 (US)
(72) Inventor: Taylor, William D., Sandy Hook, Connecticut 06482 (US)
(74) Representative: Witte, Alexander, Dr.-Ing.

(57) **Abstract**

An electrode (10) for use in a plasma reactor, and the like, is disclosed. The electrode (10) incorporates a high performance, miniature heat exchanger (20) and gas distribution manifold (20a) inside of the electrode (10). The electrode (10) comprises a bottom plate (11), a top plate (14), and an electrode holder (40). The bottom plate (11) is made of a solid heat conducting material with annular openings disposed in one surface and a gas exit pattern disposed between the annular openings and a second surface. The top plate (14) comprises gas distribution grooves that form a miniature gas distribution manifold (20a) that controllably distributes gas flow through the electrode (10), heat exchanger grooves that form the heat exchanger (20), and an opening (19) that permits gas to be supplied to the gas distribution manifold (20a). The electrode holder (40) mates to a gas input line (36) for supplying plasma gas to the electrode (10), and a coolant inlet (34) and coolant outlet (35) are provided that flow coolant to the heat exchanger (20). The design places the miniature heat exchanger (20) on top of the electrode (10) such that the heat generated by the plasma is efficiently removed while minimizing thermal gradients through the electrode (10).

## Description

### BACKGROUND

The present invention relates to a gas distribution systems for plasma reactors, and more particularly, to a cooled gas distribution system for use with plasma reactors.

The closest prior art relating to the present invention are electrodes currently used in a plasma reactor used by the assignee of the present invention to process wafers. In this prior art system, a relatively long electrode holder connects an electrode to a simple heat exchanger that is disposed approximately 1.5" away from the active (plasma contact) space of the electrode. The electrode assembly is press fit into the electrode holder. The electrode itself includes several precision machined components that are press fit together in such a fashion as to produce small annular rings through which gas flows to the plasma. The gas flow is controlled only as a function of the area ratios of the annular rings as formed by the press fit.

The annular rings may shift during etching because the heat generated by the plasma must be removed by transferring it through the press fit components of the electrode into the electrode holder and finally into the heat exchanger. This tortuous heat path creates large temperature gradients through the electrode which expands the metal from which it is made, thereby shifting the annuli formed during fabrication or changing the flow distribution to the plasma during wafer processing. A recent failure of such an electrode used in a plasma reactor showed partial fusion of the press fit components. This has been initially attributed to very large thermal gradients existing in the electrode.

Another gas distribution system for a plasma reactor uses a sintered silicon carbide electrode for the gas distribution system. Other aspects of this design are identical to those described above. However, the use of this sintered silicon carbide electrode also resulted in inefficient cooling of the electrode during wafer processing.

Therefore, it is an objective of the present invention to provide for an improved cooled gas distribution system for use with plasma reactors, and the like.

### SUMMARY OF THE INVENTION

In order to meet the above and other objectives, the present invention is a cooled gas distribution system, or electrode, for use in a plasma reactor. The present invention incorporates a high performance, miniature heat exchanger, and a gas distribution manifold inside of the plasma gas distribution system, or electrode. This design places the miniature heat exchanger on top of the electrode such that the heat generated by the plasma is efficiently removed while minimizing thermal gradients through the electrode. Further, the electrode is constructed is such a fashion as to eliminate the contact thermal conductance created by the press fit components in the heat transfer path, thereby reducing thermal gradients even further.

The miniature heat exchanger may be custom designed for any heat load generated by the plasma. The gas distribution in the electrode may be designed to provide any gas distribution profile through the electrode desired by production engineers, including, but not limited to, variations of flow rate through various parts of the electrode. This allows a production engineer to customize the shape of the plasma tool. In prior art systems, the tool shape is a function of the gas flow and is not easily customizable.

The unique features of the present invention are the use of the miniature heat exchanger in very close proximity of the heat generating plasma, the gas distribution profile in the electrode that customizes the shape of the plasma, and no thermal contact conductance to the heat exchanger. Heat transfer from the plasma to the heat exchanger is by means of solid conduction.

### BRIEF DESCRIPTION OF THE DRAWINGS

The various features and advantages of the present invention may be more readily understood with reference to the following detailed description taken in conjunction with the accompanying drawing, wherein like reference numerals designate like structural elements, and in which:
Fig. 1 shows a top view of a cooled gas distribution system, or electrode, in accordance with the principles of the present invention;
Fig. 2 shows a cross sectional view of the electrode of Fig. 1 taken along the lines 2-2 in Fig. 1;
Fig. 3 shows an enlarged cross sectional view of a portion of the electrode of Fig. 1;
Fig. 4 shows a perspective view of a bottom plate of the electrode of Fig. 1;
Fig. 5 shows a top view of the bottom plate of Fig. 4;
Fig. 6 shows a cross sectional view of the bottom plate of Fig. 4 taken along the lines 6-6 in Fig. 5;
Fig. 7 shows a perspective view of a top plate of the electrode of Fig. 1;
Fig. 8 shows a top view of the top plate of the electrode of Fig. 1;
Fig. 9 shows a cross sectional view of the plate of Fig. 8 taken along the lines 9-9 in Fig. 8; and
Fig. 10 shows a bottom view of the bottom plate of Fig. 7.

### DETAILED DESCRIPTION

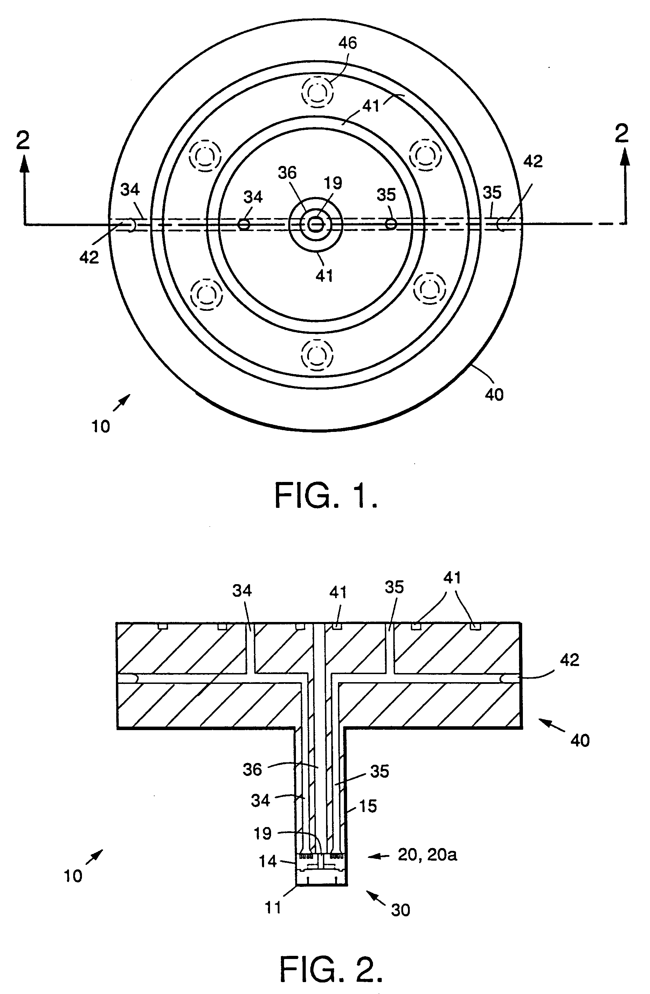

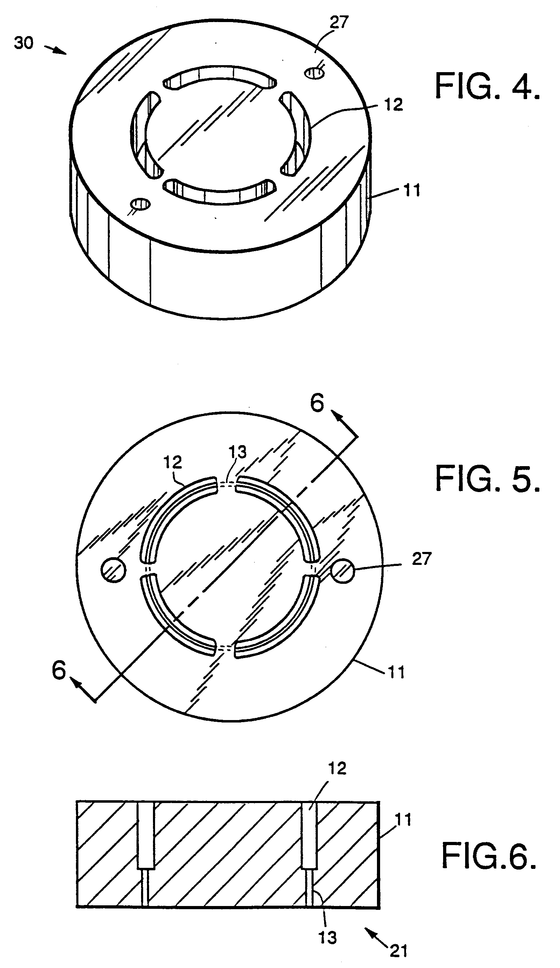

Referring to the drawing figure, Fig. 1 shows a top view of a cooled gas distribution system 10, or electrode 10, in accordance with the principles of the present invention. Fig. 2 shows a cross sectional view of the electrode 10 of Fig. 1 taken along the lines 2-2 in Fig. 1, and Fig. 3 shows an enlarged cross sectional view of a portion of the electrode 10. The electrode 10 is comprised of three separate pieces that fit into an RF head (not shown) currently-used in plasma reactors employed by the assignee of the present invention. The electrode 10 is comprised of three elements, a bottom plate 11 comprising a diffuser 30, a top plate 14 comprising a heat exchanger 20 and gas distribution manifold 20a, and an electrode holder 40 comprising a feedthrough member 15.

The electrode holder 40 has a plurality of grooves 41 disposed in its top surface that are used to interface to a mating member (not shown) disposed on the RF head. A plurality of screw holes 46 are provided that are used to secure the electrode holder 40 to the mating member on the reactor. The feedthrough member 15 and the electrode holder 40 includes a plurality of channels disposed therein that include a coolant inlet 34, a coolant outlet 35, and plasma gas supply means 36. A plurality of plugs 42 are inserted into the coolant inlet 34 and outlet 35 in order to seal them at the periphery of the electrode holder 40. The top plate 14 comprising the heat exchanger 20 and gas distribution manifold 20a has a opening 19 disposed therethrough that is coupled to gas manifold grooves 25 or gas distribution grooves 25 that form the gas distribution manifold 20a.

Referring to Fig. 3, it shows an enlarged cross sectional view of a portion of the electrode 10 detailing the interface between the feedthrough member 15, the top plate 14, and the bottom plate 11. The coolant inlet 34 and coolant outlet 35 interface to heat exchanger grooves 24 that are formed in a top surface of the top plate 14. The plasma gas port 36 interfaces with the opening 19 disposed in the top plate 14 which couples plasma gas to the gas manifold grooves 25 or gas distribution grooves 25 that form the gas distribution manifold 20a. Protrusions or pins 26 extending from a bottom surface of the top plate 14 mate with holes 27 disposed in a top surface of the bottom plate 11. The protrusions or pins 26 provide for alignment of the surfaces.

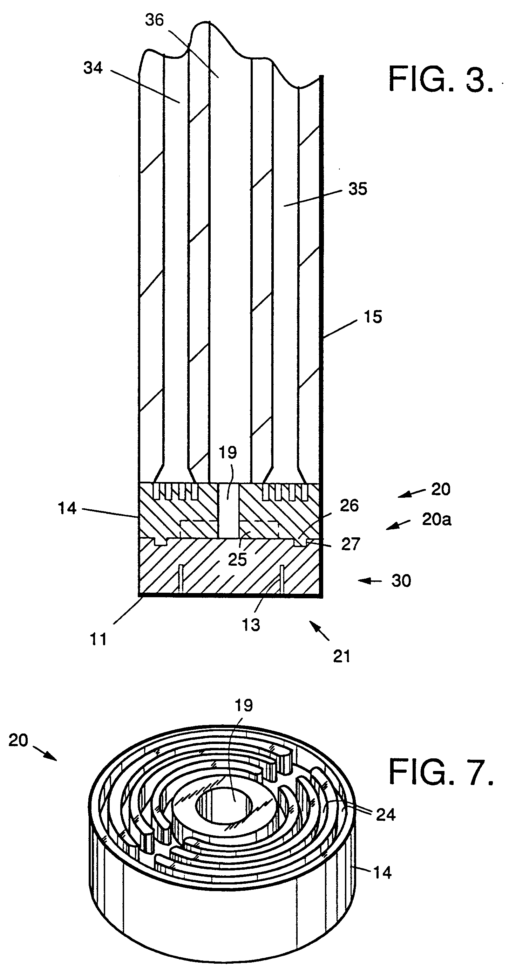

For purposes of clarity, Figs. 4-6 show details of the bottom plate 11 comprising the diffuser 30, and Figs. 7-10 show details of the top plate 14 comprising the heat exchanger 20 and gas distribution manifold 20a. Fig. 4 shows a perspective view of a bottom plate 11, Fig. 5 shows a top view of the bottom plate 11, and Fig. 6 shows a cross sectional view of the bottom plate 11 taken along the lines 6-6 in Fig. 5.

More specifically, referring to Figs. 4-6, the bottom plate 11 is comprised of a first plurality of openings 12 that are formed in one surface of the bottom plate 11. The first plurality of openings 12 may comprise annular grooves 12, for example, as shown in Fig. 4. The first plurality of openings 12 mate with a second opening 13 or plurality of openings 13 that form a gas exit pattern 21.

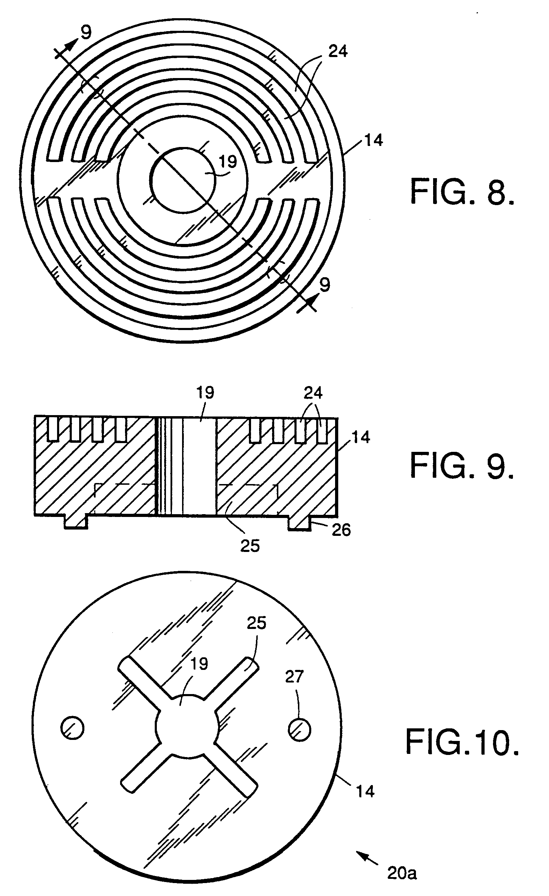

Referring to Figs. 7-10, Fig. 7 shows a perspective view of the top plate 14, Fig. 8 shows a top view of the top plate 14, Fig. 9 shows a cross sectional view of the top plate 14 taken along the lines 9-9 in Fig. 8, and Fig. 10 shows a bottom view of the bottom plate 14. The top plate 14 comprises the heat exchanger 20 and gas distribution manifold 20a. The top plate 14 comprises the heat exchanger grooves 24 that are formed in a top surface thereof. The opening 19 is disposed through that is coupled to gas manifold grooves 25 or gas distribution grooves 25 that form the gas distribution manifold 20a. Fig. 9 shows the details of the top plate 14 illustrating the cross section of the heat exchanger grooves 24 and the gas distribution grooves 25 that form the gas distribution manifold 20a. Fig. 10 shows the gas distribution grooves 25 and gas distribution manifold 20a that interfaces to the bottom plate 11.

In practice, the electrode 10 is formed by machining annular openings 12 comprising annular grooves 12 into a solid piece of heat conducting material that is compatible with the plasma chemistry of the reactor, that forms the bottom plate 11 of the electrode. The annular grooves 12 may be any width desired consistent with the desired gas distribution through the electrode 10 and standard shop practices, but the reduced to practice embodiment of the present invention, the annular grooves 12 are sized at 0.020 inches in width. The annular grooves 12 may be shaped in any pattern to provide the required flow distribution in the electrode 10. The annular grooves 12 are machined to a depth such that the remaining material on the bottom (working side) of the electrode 10 is approximately 0.02"-0.04" thick.

This thickness of the bottom portion of the bottom plate 11 is determined based on the ability to machine a gas exit pattern 21 into this surface. The gas exit pattern 21 is comprised of multiple grooves 13, holes 13, slots 13, or annuli 13, for example, approximately 0.005" maximum dimension. For the purposes of this disclosure, annuli 13 are shown in the drawing figures. The second opening 13 that form the gas exit pattern 21 may comprise slots 13 having a width of 0.005 inches that are machined as continuous annuli 13 to a depth of from 0.025-0.050 inches so that gas exhaust in uniform. The dimensions of the bottom plate 11 of the electrode 10 is kept to the above levels to facilitate the machining of the exit pattern 21 (grooves 13, holes 13, slots 13, or annuli 13) into and through the bottom plate 11 of the electrode 10.

The top plate 14 of the electrode 10 contains two sets of grooves 25, 24. One set of grooves 25, comprising the gas distribution grooves 25, is used for gas distribution, and the other set of grooves 24, or heat exchanger grooves 24, form the heat exchanger 20. The gas distribution grooves 25 are cut into a bottom surface of the top plate 14. The gas distribution grooves 25 form a miniature gas distribution manifold 20a that distributes controlled gas flow through the electrode 10 as required. The size and shape of the gas distribution grooves 25 are customized to control and deliver the flow throughout the electrode 10 as required. The design of the heat exchanger 20 is based on cooled optic technology disclosed in U.S. Patent Nos. 5,209,291 and 5,168,924 issued to William D. Taylor and assigned to the assignee of the present invention.

The heat exchanger 20 is formed by cutting the heat exchanger grooves 24 into a top surface of the top plate 14. The heat exchanger grooves 24 cover the entire top surface, as required, to provide sufficient cooling for the electrode 10.

The opening 19 is provided through the top plate 14 to permit plasma gas to be supplied to the gas distribution manifold 20a. The opening 19 may be provided by a connector, such as a threaded tap or other pipe connector, for example, that may be machined into the top plate 14, or a connector or other fitting that may be brazed or soldered to the top plate 14. In a reduced to practice embodiment of the present invention, the components are brazed together. Brazing the components together also seals the top surface of the top plate 14 to the electrode holder 40 to permit coolant to be contained within the heat exchanger 20.

The electrode holder 40 is substantially the same as the design described in the Background section above. A threaded or other suitable connection is provided to mate to the plasma gas port 36 and a machined surface is provided to seal to the heat exchanger 20. The coolant inlet 34 and coolant outlet 35 are provided through the electrode holder 40. The coolant inlet 34 and coolant outlet 35 are designed to provide proper coolant flow distribution to the heat exchanger 20.

The top and bottom plates 14, 11 of the electrode 10 are brazed or soldered, or otherwise bonded together to provide solid thermal conduction from the working surface of the electrode 10 to the heat exchanger 20. Once completed, the electrode 10 is attached, by brazing, bonding, or welding, or the like, to the electrode holder 40 and the heat exchanger 20 is sealed. This subassembly is then secured to the RF head that is then installed into the plasma reactor.

The present invention places the miniature heat exchanger 20 in very close proximity to a heat generating plasma, and provides for a gas distribution profile in the electrode 10 that customizes the shape of the plasma. The present invention may be used for flattening of semiconductor wafers. The present cooled electrode 10 may also be used with other plasma etching application when large amounts of power must be removed from the electrode 10.

Thus there has been described a new and improved cooled gas distribution system for use with plasma reactors. It is to be understood that the above-described embodiment is merely illustrative of some of the many specific embodiments that represent applications of the principles of the present invention. Clearly, numerous and other arrangements can be readily devised by those skilled in the art without departing from the scope of the invention.

## Claims

1. An electrode for use with a plasma reactor, comprising an electrode holder (40) having an elongate member (15) with a gas exit plate assembly (11, 14) at a terminal end thereof and defining a bottom working side of the electrode (10), plasma gas supply means (36) being provided for supplying plasma gas to the gas exit plate assembly (11, 14), and a heat exchanger (20) for cooling the electrode (10) and comprising a coolant inlet (34) as well as a coolant outlet (35) for coupling coolant through the heat exchanger (20), characterized in that the heat exchanger (20) is integrated into the gas exit plate assembly (11, 14).

2. The electrode of claim 1, characterized in that the gas exit plate assembly (11, 14) is provided with heat exchanger grooves (24) disposed on a surface of the gas exit plate assembly (11, 14) opposite the bottom working side, the coolant inlet (34) and the coolant outlet (35) extending through the elongate member (15) and communicating with the heat exchanger groove (24).

3. An electrode for use with a plasma reactor, comprising an electrode holder (40) having an elongate member (15) with a gas exit plate assembly (11, 14) at a terminal end thereof and defining a bottom working side of the electrode (10), plasma gas supply means (36) being provided for supplying plasma gas to the gas exit plate assembly (11, 14), characterized in that the gas exit plate assembly (11, 14) comprises a plasma gas diffusor (30) with a gas distribution manifold (20a) integrated into the gas exit plate assembly (11, 14).

4. The electrode of claim 3, characterized in that the gas exit plate assembly (11, 14) comprises a bottom plate (14) and a top plate (11), the bottom plate (14) having first openings (12) disposed in a top surface thereof and second openings (13) forming a gas exit pattern (21) and disposed in a bottom surface thereof, thus defining the bottom working side, the top plate (11) having a set of gas distribution grooves (25) disposed adjacent the annular openings (12) of the bottom plate (11) and means (19) for supplying gas to the gas distribution grooves (25).

5. The electrode of claim 4, characterized in that the first openings (12) are configured as arcs.

6. The electrode of claim 5, characterized in that the second openings (13) are configured as one annular opening having the same radius as but a smaller radial width than the arcs.

7. The electrode of any of claims 4 - 6, characterized in that the second openings are configured as multiple grooves, holes, slots or annuli.

8. The electrode of any of claims 4 - 7, characterized in that the gas distribution grooves (25) are configured as a cross in a radial plane.

9. The electrode of any of claims 3 - 8, characterized in that the top plate (11) is provided with a heat exchanger (20) for cooling the electrode (10) and comprising a coolant inlet (34) as well as a coolant outlet (35) for coupling coolant through the heat exchanger (20), the top plate (11) having heat exchanger grooves (24) disposed on a top surface thereof opposite the bottom working side, the coolant inlet (34) and the coolant outlet (35) extending through the elongate member (15) and communicating with the heat exchanger grooves (24).

10. An electrode for use with a plasma reactor, characterized by:
- a bottom plate (11) comprising a solid heat conducting member having annular openings (12) disposed in a first surface thereof, and having a gas exit pattern (21) disposed between the annular openings (12) and a second surface thereof;
- a top plate (14) comprising:
-- a set of gas distribution grooves (25) disposed adjacent the annular openings (12) of the bottom plate (11) that comprise a gas distribution manifold (20a) for controllably distributing gas flow through the electrode (10),
-- a plurality of heat exchanger grooves (24) disposed adjacent an opposite surface of the top plate (14) that comprise a heat exchanger (20); and
-- means (19) for supplying gas to the gas distribution manifold (20a); and
- an electrode holder (40) disposed adjacent the gas distribution grooves (24) of the top plate (14) that comprises:
-- plasma gas supply means (36) for supplying plasma gas to the electrode (10); and
-- a coolant inlet (34) and a coolant outlet (35) for coupling coolant through the heat exchanger (20).

11. The electrode of claim 10, characterized in that the annular openings (12) comprise grooves that are machined to a predetermined depth such that the material remaining on a bottom working side of the electrode (10) has a predetermined thickness.

12. The electrode of claim 10 or 11, characterized in that the gas exit pattern (21) is comprised of multiple grooves, holes, slots or annuli.
